# EUROPÄISCHE PATENTSCHRIFT

(11) **EP 3 320 761 B1**
(45) Veröffentlichungstag und Bekanntmachung des Hinweises auf die Patenterteilung: **07.08.2019**
(21) Anmeldenummer: 16733021.6
(22) Anmeldetag: 20.06.2016
(51) Int. Cl.: H05K 5/06

(54) **MEHRTEILIGE VORRICHTUNG SOWIE VERFAHREN ZUR HERSTELLUNG DIESER MEHRTEILIGE VORRICHTUNG**
MULTI-PART DEVICE AND METHOD FOR MANUFACTURING THIS MULTI-PART DEVICE
DISPOSITIF À PLUSIEURS PARTIES ET PROCÉDÉ DE FABRICATION DE CE DISPOSITIF À PLUSIEURS PARTIES

(30) Priorität: 07.07.2015 DE 102015212680
(43) Veröffentlichungstag der Anmeldung: 16.05.2018
(73) Patentinhaber: Robert Bosch GmbH, 70442 Stuttgart (DE)
(72) Erfinder: SCHALOWSKI, Gerhard, 72581 Dettingen (DE); ROTHER, Christian, 72766 Reutlingen (DE); KIM, Hack-Min, 71034 Boeblingen (DE); SEGIET, Raphael, 72770 Reutlingen (DE); KIMPEL, Thomas, 70825 Korntal-Muenchingen (DE); WAGNER, Walter, 72762 Reutlingen (DE)
(86) Internationale Anmeldenummer: PCT/EP2016/064121
(87) Internationale Veröffentlichungsnummer: WO 2017/005476

(56) Entgegenhaltungen:
- EP-A2- 1 501 341
- US-A1- 2015 145 386

## Beschreibung

Die Erfindung betrifft eine Fixierung eines Fügepartners auf einem Substrat mit einem Fixierelement und einem Ausgleichselement um zum Beispiel Rissbildungen im Fixierelement durch wechselnde thermische Ausdehnungsänderungen zu vermeiden und eine optimierte Dichtfunktion zu realisieren sowie ein Verfahren zur Herstellung dieser Fixierung.

### Stand der Technik

Elektronische Bauteile können durch Wasser oder Staub geschädigt werden. Im Automobilbereich werden deshalb an ein Gehäuse eines sicherheitsrelevanten Bauteils hohe Anforderungen an eine Abdichtung gestellt. Beispielsweise sollen über die geforderte Produktlebenszeit keine Materialermüdungen an einem Dichtmaterial durch auftretende Ausdehnungsänderungen bei Temperaturwechseln resultieren.

Es ist durch den Stand der Technik bekannt, dass Gehäusekomponenten mit mechanischen Schrauben fixiert und an Fügestellen elastische Dichtungen vorgesehen werden können. Durch diesen Ansatz werden üblicherweise eine Gehäuseabdichtung gegenüber Umgebungseinflüssen und eine Fixierung der Gehäusekomponenten erreicht. Es ist des Weiteren bekannt, dass einige technische und wirtschaftliche Vorteile durch Einsatz von flächigen statt mechanischen Fixierelementen resultieren können, wie beispielsweise bei Verwendung eines Klebers statt einer Schraubverbindung. Aus DE 4340108 C2 und DE 29819434 U1 ist außerdem bekannt, dass beim Fügen von Gehäusekomponenten eine verbesserte Dichtung erzielt werden kann, wenn nebeneinander angeordnete Dosierstränge mit unterschiedlichen Eigenschaften verwendet werden.

Das Dokument EP 1501341 A2 offenbart die Merkmale des kennzeichnenden Teils von Anspruch 1.

Die vorliegende Erfindung hat abgrenzend zum vorangehend beschriebenen Stand der Technik zur Aufgabe, Rissbildung in einem Fixierelement aufgrund von Ausdehnungsänderungen durch wechselnde Temperaturen oder aufgrund von Mikrobewegungen zu vermeiden. Außerdem soll die Wirkung einer möglichen Rissbildung im Fixierelement minimiert werden. Ziel ist, eine gute Dichtung einer Fixierung mit einem Fixierelement zu realisieren.

### Offenbarung der Erfindung

Die Erfindung betrifft eine Vorrichtung und ein Verfahren zur Fixierung eines Fügepartners mit einem Fixierelement und einem Ausgleichselement. Zur Lösung obiger Aufgabe wird ein Substrat mit einer Ausnehmung auf der Substratoberfläche verwendet. In die zumindest teilweise mit einem Fixierelement gefüllte Ausnehmung ragt ein Fügepartner mit einer Eintauchtiefe hinein, wobei der Fügepartner durch ein Aushärten des Fixierelementes an dem Substrat fixiert wird. Erfindungsgemäß ist ein Ausgleichselement zwischen dem Fügepartner und dem Fixierelement angeordnet. Das Ausgleichselement ist insbesondere aus einem elastischen Dichtungsmaterial. Das Ausgleichselement ist in Kontakt zum Fügepartner und zum Fixierelement. Es ist des Weiteren zumindest teilweise innerhalb der Eintauchtiefe des Fügepartners in das Fixierelement angeordnet. Der Vorteil dieser Anordnung ist, dass eine thermische Ausdehnungsänderung oder eine mechanische Bewegung des Fixierelementes, des Substrats oder des Fügepartners durch eine elastische Stauchung oder Dehnung des Ausgleichselementes ausgeglichen werden kann. Eine solche Lösung kann außerdem Kosten reduzieren, weil beispielsweise mechanische Fixierungselemente wegfallen und/oder eine Vereinfachung des Montageprozesses erfolgt.

Mögliche Ausführungsformen des Fügepartners im Bereich der Eintauchtiefe sind beispielsweise eine abgerundete Kante, eine Spitze oder eine rechteckige Form.

Der Fügepartner weist im Bereich der Eintauchtiefe in die Ausnehmung also mindestens eine Fläche auf. Alternativ weist der Fügepartner auch eine erste Seite und eine zweite Seite sowie möglicherweise eine Unterseite im Bereich der Eintauchtiefe auf. Das Ausgleichselement kann mindestens teilweise an der Fläche des Fügepartners bzw. an der ersten Seite, an der zweiten Seite und/oder an der Unterseite des Fügepartners angeordnet werden. Vorteilhafterweise wird das Ausgleichselement dort angeordnet, wo die größte Belastung innerhalb des Fixierelementes im fixierten Zustand auftritt. Die Belastung ist insbesondere eine thermische Ausdehnungsänderung oder eine Bewegung des Fixierelementes, des Fügepartners und/oder des Substrates.

In einer alternativen Ausführung, können an mehreren Stellen an der Fläche des Fügepartners bzw. an der ersten Seite, an der zweiten Seite und/oder an der Unterseite Ausgleichselemente erfindungsgemäß angeordnet werden. Zwischen den Ausgleichselementen ist dabei das Fixierelement angeordnet. Durch eine solche Ausführung wird eine Belastung, wie beispielsweise eine durch thermische Ausdehnung resultierende Volumenänderung des Fixierelementes, auf mehrere Ausgleichselemente verteilt, was die Wahrscheinlichkeit einer Rissbildung minimiert. Außerdem kann ein möglicher Defekt in einem Ausgleichselement durch ein anderes Ausgleichselement ausgeglichen und damit die Dichtung redundant und somit robuster gegenüber Verschmutzungen, Dosier- und/oder Materialfehlern ausgelegt werden.

In vorteilhafter Weise wird das Ausgleichselement vor dem Fügen auf dem Fügepartner aufgetragen, weil das Ausgleichselement dann genau positioniert werden kann. Damit eine Abdichtung des Fügepartners erreicht und das Ausgleichselement nicht während des Fügens verschoben wird, sollte eine Haftung zwischen dem Ausgleichselement und dem Fügepartner größer als diejenige zwischen dem Ausgleichselement und dem Fixierelement sein. Die Haftung kann durch eine geeignete Materialwahl des Fügepartners und/oder des Ausgleichselementes und/oder durch eine Vorbehandlung oder Beschichtung des Fügepartners positiv beeinflusst werden. Die erhöhte Haftung kann auch durch zumindest teilweise erfolgte thermische oder chemische Aushärtung des Ausgleichselementes vor dem Fügen erreicht werden.

Eine alternative Ausführungsform ist die Aufbringung des Ausgleichselementes auf der Fixierelementoberfläche in der Ausnehmung vor dem Fügen. Die Aufbringung des Ausgleichselementes auf der Fixierelementoberfläche kann dabei partiell oder auch ganzflächig erfolgen. Diese Ausführungsform der Aufbringung kann einen Kostenvorteil aufweisen, weil der Fertigungsprozess durch eine hintereinander geschaltete, parallele Dosierung des Fixierelementes und des Ausgleichselementes vereinfacht werden kann. Die erfindungsgemäße Positionierung des Ausgleichselementes zwischen dem Fixierelement und dem Fügepartner bei Aufbringung auf der Fixierelementoberfläche kann durch ein geeignetes Fügeverfahren erzielt werden. Die Positionierung kann durch eine hohe Viskosität des Ausgleichselementes gegenüber dem Fixierelement, durch eine gute Haftung zwischen dem Ausgleichselement und dem Fügepartner, durch einen schnellen Fügeprozess, durch einen genau positionierten Fügeprozess und/oder durch eine Teilbedeckung der Fixierelementoberfläche mit dem Ausgleichselement erreicht werden.

Die Ausnehmung auf der Substratoberfläche mit einer Ausnehmungstiefe kann des Weiteren beispielsweise im Querschnitt als trapezförmiger Graben ausgeprägt sein. Dies erlaubt eine automatische, formschlüssige Feinzentrierung beim Fügeprozess.

Eine gute Fixierung des Fügepartners an das Substrat und ein Ausgleichen der Belastungen durch die Elastizität des Ausgleichselementes erfordern je nach Art und Stärke der Belastung Mindestdimensionen des Ausgleichelementes und des Fixierelementes in der Ausnehmung. In einer vorteilhaften Ausführungsform ist die Ausnehmung vor dem Fügen zu mindestens zwei Dritteln mit dem Fixierelement gefüllt. Die Höhe des Fixierelements in der Ausnehmung über einem Ausnehmungsboden und vor dem Fügen wird als Fixierelementhöhe bezeichnet. Vorteilhafterweise beträgt die Eintauchtiefe des Fügepartners in das Fixierelement zumindest sechzig Prozent der Fixierelementhöhe. Des Weiteren beträgt vorteilhafterweise eine Ausgleichshöhe im Fixierelement mindestens ein Fünftel der Eintauchtiefe. Außerdem beträgt in einer Weiterentwicklung der Erfindung im Bereich der Ausgleichshöhe eine Ausgleichselementbreite ein Drittel der Fixierelementbreite.

Des Weiteren lässt sich zwischen einem Ausnehmungsboden und dem fixierten Fügepartner eine Fügehöhe definieren. In einer vorteilhaften Ausführungsform ist das Fixierelement unterhalb des Fügepartners angeordnet. Durch eine resultierende Fügehöhe können über eine zusätzliche Anordnung des Ausgleichselementes an einer Unterseite thermische Ausdehnungen des Fixierelementes zentraler als an bei Anordnung in der Nähe der Fixierelementoberfläche ausgeglichen werden.

In einer alternativen Ausführungsform wird der Ausnehmungsboden im Verfahren während des Fügens als ein mechanischer Anschlag für die Positionierung des Fügepartners verwendet. Der Fügepartner taucht also bis zum Ausnehmungsboden ein. Um in dieser Ausführungsform der erfindungsgemäßen Vorrichtung einen guten Ausgleich der mechanischen und thermischen Belastungen zu erreichen, kann das Ausgleichselement beispielsweise zweiseitig aufgetragen werden. Um in dieser Ausführungsform die Fixierung ausreichend stabil zu gestalten, kann die Ausnehmung durch Erhöhung einer Ausnehmungstiefe tiefer ausgeführt und damit die Eintauchtiefe des Fügepartners in das Fixierelement erhöht werden.

Die Erfindung kann für unterschiedliche Geometrien und Zwecke angewandt werden. Eine Ausnehmung auf der Substratoberfläche kann in der Aufsicht sowohl punktförmig, kreisförmig, elliptisch, linienförmig, rechteckig oder trapezförmig als auch in einer Freiform verlaufen. Beispielsweise kann die Erfindung sowohl zur Befestigung in einem Loch als auch in einer linienförmigen Ausnehmung dienen. Die Ausnehmung kann in der Aufsicht auch einen Substratbereich auf der Oberfläche des Substrates einschließen. Der Fügepartner kann des Weiteren ebenfalls auf vielfältige Art ausgeführt sein, wie zum Beispiel als Stange oder als Blech. Gegebenenfalls verfügt der Fügepartner im Bereich der Eintauchtiefe, d.h. im Bereich der Fixierung, auch über eine zusätzliche Ausformung.

Schließt die Ausnehmung in der Aufsicht auf der Oberfläche einen Substratbereich ein und liegt ein als Kappe ausgeprägter Fügepartner vor, so können in einer bevorzugten Ausgestaltung der Erfindung das Substrat, das Fixierelement, das Ausgleichselement und der Fügepartner einen gegen die Umgebung abgetrennten Raum bilden. Das Substrat, das Fixierelement, das Ausgleichselement und der Fügepartner realisieren damit ein Gehäuse, welches beispielsweise für den Schutz einer elektrischen Schaltung oder eines elektrischen Sensors vor Umgebungseinflüssen genutzt werden kann.

In einer alternativen Ausprägung des Verfahrens erfolgt ein chemisches oder thermisches Teilaushärten des Fixierelementes vor dem Fügen. Dies ist vorteilhaft, wenn beispielsweise die Aushärtezeit nach dem Fügen reduziert werden soll. Durch Reduktion der Aushärtezeit nach dem Fügen kann die Vorrichtung schnell weiter gehandhabt oder verpackt werden. Außerdem kann eine thermische Teilaushärtung vor dem Fügen notwendig sein, wenn beispielsweise integrierte oder angefügte Bauteile temperaturempfindlich sind.

In einer alternativen, vorteilhaften Ausgestaltung des Verfahrens erfolgen das chemische oder thermische Aushärten des Fixierelementes und des Ausgleichselementes zusammen nach dem Fügen. Ein Vorteil einer gemeinsamen Aushärtung kann beispielsweise eine mögliche Reduktion eines thermischen Heizprozesses und den damit verbundenen Kosten sein.

### Zeichnungen

Fig. 1 zeigt ein erfindungsgemäßes Ablaufdiagramm mit den Prozessschritten des Verfahrens.
Fig. 2a zeigt das Verfahrensprinzip des Fügens zur Herstellung einer erfindungsgemäßen Vorrichtung im Querschnitt.
Fig. 2b zeigt die nach Fig 2a resultierende, erfindungsgemäße Vorrichtung in einem ersten Ausführungsbeispiel nach dem Fügen.
Fig. 3 zeigt die Aufsicht der nach Fig. 2b dargestellten Fixierung bei einem ebenen, rechteckigen Fügepartner.
Fig.4 zeigt als zweites Ausführungsbeispiel die Fixierung eines rechteckigen Fügepartners in Aufsicht, wenn im Verfahrensschritt 103 die Aufbringung des Ausgleichselementes vollständig auf der Oberfläche des Fixierelementes und nicht, wie in Fig 2a dargestellt, am Fügepartner erfolgt.
Fig.5 zeigt das in Fig. 4 dargestellte Ausführungsbeispiel im Querschnitt.
Fig.6 zeigt ein drittes Ausführungsbeispiel der erfindungsgemäßen Vorrichtung im Querschnitt bei zweiseitiger Anordnung des Ausgleichselementes auf dem Fügepartner.
Fig. 7 zeigt ein viertes Ausführungsbeispiel der erfindungsgemäßen Vorrichtung im Querschnitt, wobei das Ausgleichselement von der ersten Seite bis zur Unterseite des Fügepartners angeordnet ist.
Fig. 8 zeigt ein Ausführungsbeispiel in Aufsicht, wobei die Ausnehmung auf dem Substrat einen Substratbereich auf einer Substratoberfläche einschließt.
Fig. 9 zeigt im Querschnitt ein Ausführungsbeispiel der erfindungsgemäßen Vorrichtung zur Herstellung eines gegen die Umgebung abgetrennten Raumes mittels eines als Kappe ausgeprägten Fügepartners und einer Ausnehmung, welche auf dem Substrat einen Substratbereich auf einer Substratoberfläche einschließt.
Fig. 10 zeigt ein Ausführungsbeispiel der erfindungsgemäßen Vorrichtung im Querschnitt bei mehrfacher Anordnung des Ausgleichselementes auf dem Fügepartner.

### Ausführungsbeispiele

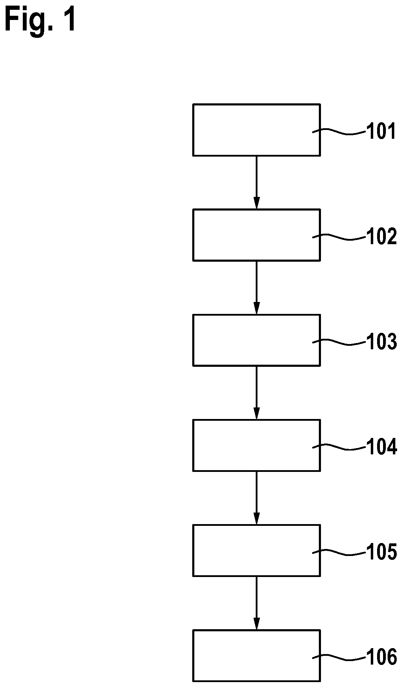

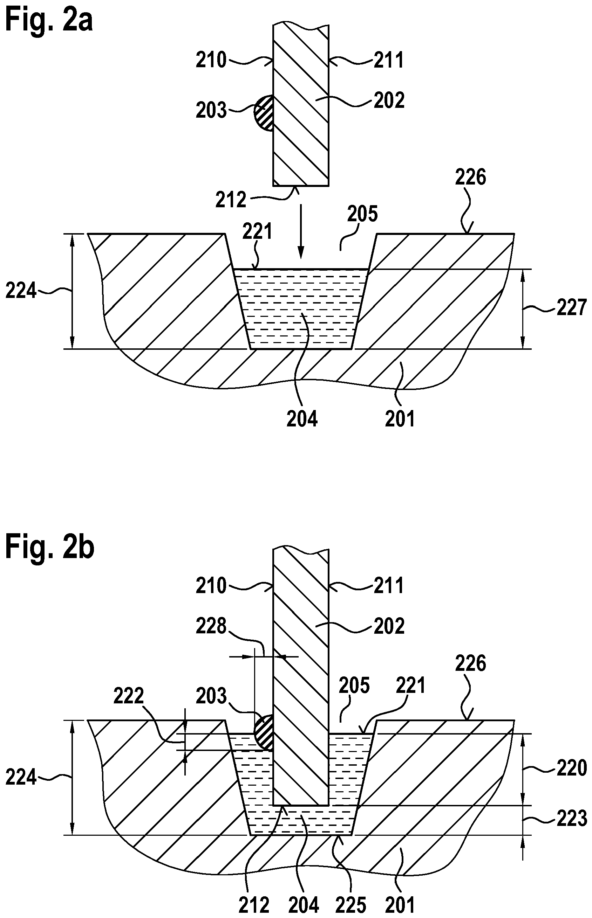

In Fig. 1 ist das Verfahren zur Herstellung einer erfindungsgemäßen Vorrichtung, wie in Fig. 2b im Querschnitt dargestellt, beschrieben. In einem ersten Verfahrensschritt 101 erfolgt eine Verwendung eines Substrates 201 mit einer Ausnehmung 205 auf der Substratoberfläche 226 und einer Ausnehmungstiefe 224. In einem zweiten Schritt 102 wird ein Fixierelement 204 in die Ausnehmung 205 aufgebracht. Das Fixierelement ist dabei insbesondere ein Kleber. Erfindungsgemäß erfolgt im dritten Verfahrensschritt 103 eine Aufbringung eines Ausgleichselementes 203 auf einem Fügepartner 202. Das Ausgleichselement 203 umfasst dabei insbesondere ein Dichtungsmaterial. Im Anschluss wird im vierten Verfahrensschritt 104 eine wenigstens teilweise chemische oder thermische Aushärtung des Ausgleichselementes 203 durchgeführt. Beim fünften Schritt 105, dem in Fig. 2a dargestellten Fügen, wird der Fügepartner 202 zum Substrat 201 positioniert und in die mit dem Fixierelement 204 gefüllte Ausnehmung mit einer Eintauchtiefe 220 eingebracht. Die Ausnehmung 205 ist in Fig. 2a im Querschnitt trapezförmig ausgeführt: Dies erlaubt eine automatische Zentrierung beim Fügen 105. Der in Fig. 2b nach dem Fügen resultierende, vertikale Abstand zwischen dem Fügepartner 202 und einem Ausnehmungsboden 225 wird als Fügehöhe 223 bezeichnet. Die in Fig. 2b mit der Fügehöhe 223 erzielte, vollständige Umfassung des Fügepartners durch das Fixierelement in der Ausnehmung erlaubt eine starke Fixierung von dem Substrat 201 und dem Fügepartner 202 und einen fertigungstechnisch einfachen Dosierprozess. Die Ausgleichshöhe 222 ist als eine Strecke innerhalb der Eintauchtiefe 220, an der das Ausgleichselement zwischen dem Fügepartner 202 und dem Fixierelement 204 angeordnet ist, definiert. Als letzter Verfahrensschritt 106 erfolgt eine Fixierung des Substrates 201 mit dem Fügepartner 202 durch eine chemische oder thermische Aushärtung des Fixierelementes 204.

Die nach dem in Fig. 1 dargestellten Verfahren hergestellte, erfindungsgemäße Vorrichtung aus Fig. 2b kann beispielsweise eine Fixierung einer Stange in einer lochförmigen Ausnehmung, eine Fixierung eines geraden, ebenen Bleches in einer linienförmigen Ausnehmung oder eine Fixierung einer runden Kappe in einer kreisförmigen Ausnehmung zur Herstellung eines Gehäuses sein. Durch eine nach diesem Verfahren hergestellte Vorrichtung, können Belastungen, wie zum Beispiel thermische Ausdehnungsänderungen des Fixierelementes 204 ausgeglichen oder möglicherweise entstehende Mikrorisse im Fixierelement 204 abgedichtet werden.

Die Prozessschritte 102 und 103 des in Fig. 1 dargestellten Verfahrens, d.h. die Aufbringung des Fixierelementes 204 und die Aufbringung des Ausgleichselementes 203, können im zeitlichen Ablauf vertauscht werden bzw. parallel ablaufen. Dies weist fertigungstechnische Vorteile, beispielsweise zur Taktzeitreduktion, auf.

Als alternative Ausführung des in Fig. 1 dargestellten Verfahrens, kann der vierte Schritt 104 zur chemischen oder thermischen Aushärtung des Ausgleichselementes 203 zusammen mit dem sechsten Schritt 106 zur chemischen oder thermischen Aushärtung des Fixierelementes 204 erfolgen. Dadurch können niedrigere Fertigungskosten erreicht werden, weil ein teurer Verfahrensschritt entfällt und so ingesamt das Verfahren verkürzt werden kann.

Als weitere Ausführungsform des in Fig. 1 dargestellten Verfahrens, kann eine chemische oder thermische Teilaushärtung des Fixierelementes 204 vor dem Fügen erfolgen. Eine chemische Aushärtung bedeutet in diesem Zusammenhang, dass insbesondere ein Kleber durch chemische Reaktion selbständig vernetzten und damit aushärten kann. Eine Teilaushärtung des Fixierelementes 204 vor dem Fügen kann die chemische oder thermische Aushärtezeit nach dem Fügen im Schritt 106 reduzieren oder überflüssig machen. In dieser Ausgestaltung des Verfahrens kann beispielsweise ein Bauteil mit einer erfindungsgemäßen Vorrichtung nach dem Fügen schnell für einen Transport verpackt werden.

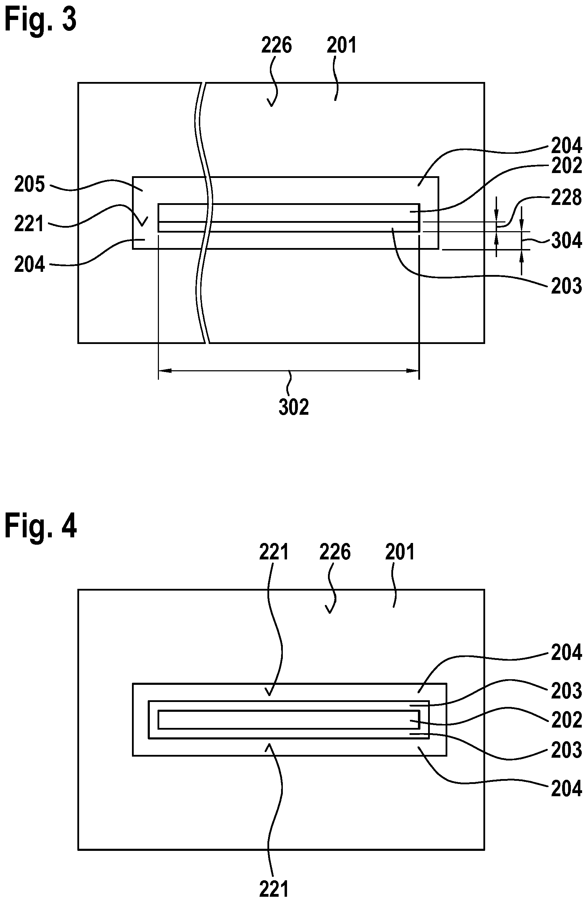

Fig. 3 zeigt in der Aufsicht die nach Fig. 2b resultierende Fixierung bei einem rechteckig ausgeformten Fügepartner 202. Es ist eine mit einem Fixierelement 203 gefüllte, gerade Ausnehmung 205 auf einem Substrat 201 zu erkennen, wobei erfindungsgemäß ein Ausgleichselement 203 an einer ersten Seite 210 des Fügepartners 202 angeordnet ist. Es ist zum Ausgleich der thermischen und mechanischen Belastungen und insbesondere für die Dichtfunktion vorteilhaft, dass das Ausgleichselement vollständig über die Fügepartnerlänge 302 angeordnet ist, wie in Fig. 3 dargestellt. Außerdem ist zu erkennen, dass die Ausgleichselementbreite 228 genauso breit, wie die Fixierelementbreite 304 ist. So kann durch das Ausgleichselement eine Belastung gut ausgeglichen werden, wenn die Ausgleichhöhe 222 ausreichend groß ist.

Alternativ kann die Ausgleichselementbreite 228 schmäler oder breiter als die Fixierelementbreite 304 sein, wobei eine breite Ausgestaltung bei erfindungsgemäßer Anordnung und ausreichender Ausgleichhöhe 222 die ausgleichbaren Belastungen und die Dichtfunktion erhöht. Deshalb beträgt in einer vorteilhaften Ausgestaltung die Ausgleichselementbreite 228 mindestens ein Drittel der Fixierelementbreite 304 und die Ausgleichshöhe 222 im Fixierelement 204 ist mindestens ein Fünftel der Eintauchtiefe 220.

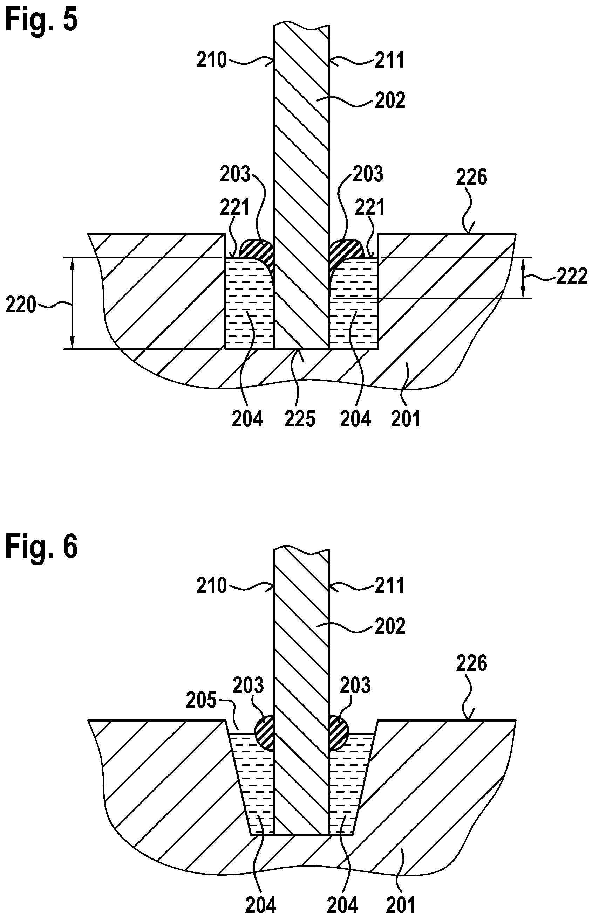

In einer alternativen Ausführung der Erfindung erfolgt in Prozessschritt 103 die Aufbringung des Ausgleichselementes 203 auf die Fixierelementoberfläche 221. Diese Ausführung erzeugt einen Kostenvorteil, weil der Fertigungsprozess durch eine hintereinander geschaltete, parallele Dosierung des Fixierelementes 204 und des Ausgleichselementes 203 vereinfacht werden kann. Wie in Fig. 4 dargestellt, kann in einer Ausgestaltungsvariante das Ausgleichselement 203 zumindest teilweise die Fixierelementoberfläche 221 bedecken. Damit resultiert der Vorteil, dass eine verbesserte Dichtfunktion erreicht wird. Dies ist in Fig. 5 auch in einem zu Fig. 4 passenden Vorrichtungsquerschnitt dargestellt. Die Anordnung des Ausgleichselementes 203 an der Fixierelementoberfläche 221 ist zu erkennen.

Ein weiteres Ausführungsbeispiel ist in Fig. 6 im Querschnitt zu erkennen. Der Fügepartner taucht bis zum Ausnehmungsboden 225 ein. Der Fügepartner weist außerdem eine rechteckige Form im Bereich der Eintauchtiefe 220 und damit eine erste Seite 210 und eine zweite Seite 211 auf. Das Ausgleichselement 203 wird zweimal und gegenüber liegend an der ersten Seite 210 und der zweiten Seite 211 des Fügepartners 202 angeordnet. Dies hat den Vorteil eines verbesserten Ausgleichs von Ausdehnungsänderungen und/oder mechanischen Bewegungen. Die Anordnung nach Fig. 6 realisiert außerdem eine optimierte Dichtfunktion.

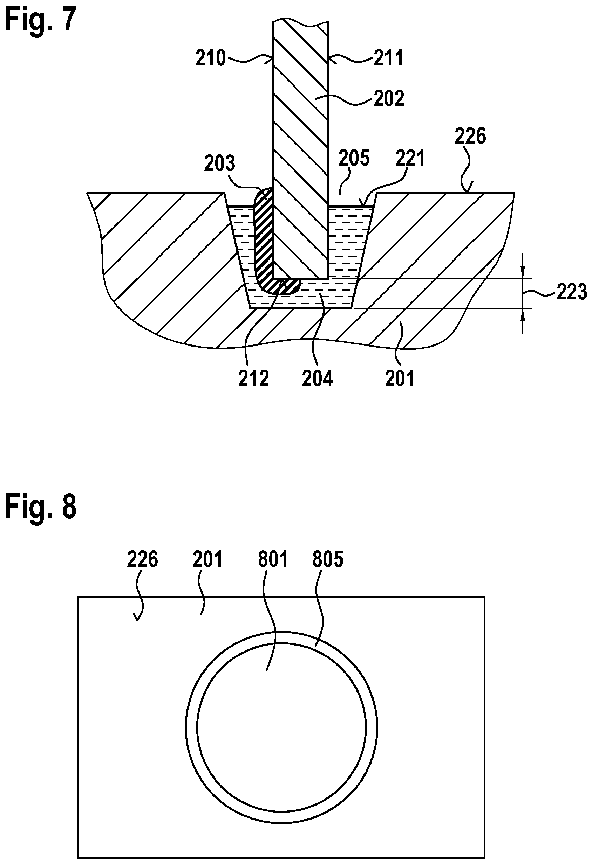

Ein weiteres Ausführungsbeispiel ist in Fig. 7 im Querschnitt zu erkennen. Der Fügepartner weist eine rechteckige Form im Bereich der Eintauchtiefe 220 und eine Fügehöhe 223 auf. Er verfügt damit über eine erste Seite 210, eine zweite Seite 211 und eine Unterseite 212. In diesem Fall wird das Ausgleichselement 203 von der ersten Seite 210 bis zur Unterseite 212 angeordnet. Dies hat gegenüber dem Beispiel aus Fig. 2b den Vorteil eines verbesserten Ausgleichs der Belastungen, also der Ausdehnungsänderungen und der mechanischen Bewegungen.

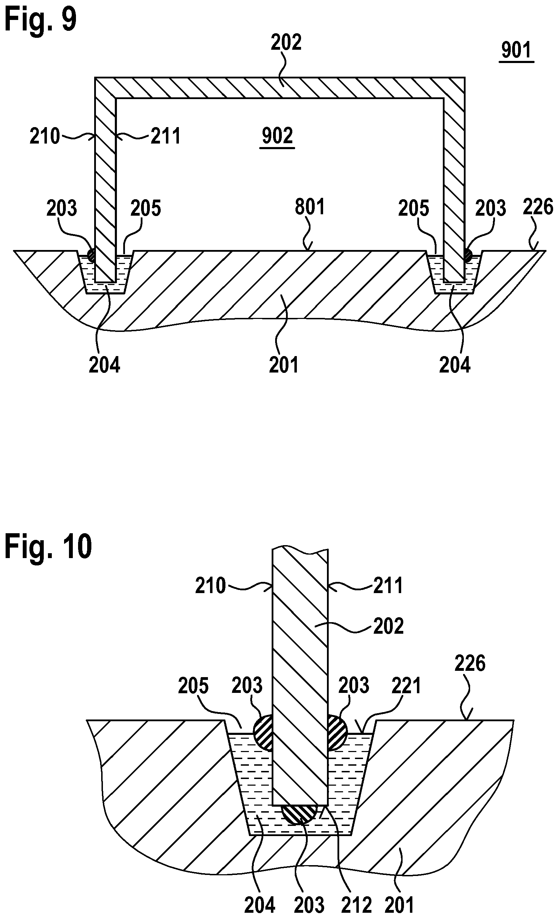

Fig. 8 zeigt in der Aufsicht ein Substrat 201 mit einer kreisförmigen Ausnehmung 805 auf der Substratoberfläche 226, wobei ein Substratbereich 801 auf der Substratoberfläche 226 eingeschlossen wird. Eine solche Ausgestaltung der Ausnehmung 205 wird benötigt, um, wie in Fig. 9 dargestellt, zusammen mit einem als Kappe ausgeformten Fügepartner, einen gegenüber der Umgebung abgetrennten Raum zu realisieren.

Das Ausführungsbeispiel in Fig. 9 zeigt im Querschnitt eine Ausnehmung 205, 805 auf dem Substrat 201, wobei die Ausnehmung 205, 805, wie in Fig. 8 dargestellt, kreisförmig einen Substratbereich 801 auf einer Substratoberfläche 226 einschließt. Der Fügepartner 202 ist außerdem als Kappe ausgeprägt. In diesem Beispiel ist die erfindungsgemäße Vorrichtung, ähnlich wie in Fig. 2b dargestellt, so ausgeführt, dass das Ausgleichselement auf der ersten Seite 210 in das Fixierelement 204 eintaucht. Durch das Fügen bilden damit das Substrat 201, der Fügepartner 202, das Fixierelement 204 und das Ausgleichselement 203 einen gegen eine Umgebung 901 abgeschlossenen Raum 902. Das Ausgleichselement 203 dichtet in diesem Beispiel den Raum 902 von außen gegen Einflüsse der Umgebung 901 ab.

Auf dem Substrat und innerhalb des von der Ausnehmung eingeschlossenen Bereiches können beispielsweise elektrische Bauteile, wie elektrische Schaltungen oder Sensoren, platziert werden. Durch das Fügen befinden sich die elektrischen Bauteile im abgeschlossenen Raum 902. Sie sind deshalb beispielsweise vor Wasser oder Staub geschützt.

Enthält der als Kappe ausgeprägte Fügepartner 202 zum Beispiel zusätzlich eine flexible Membran zum Druckausgleich zwischen der Umgebung 901 und dem Raum 902, so können auch Drucksensoren für die Umgebung im Raum 902 verwendet und gegenüber schädlichen Umgebungseinflüssen geschützt werden.

Alternativ könnte die Ausnehmung 805 in Fig. 8 auch elliptisch, quadratisch, rechteckig, trapezförmig oder in einer freien Form verlaufen. Zur Realisierung eines abgetrennten Raumes muss dann der Fügepartner ebenfalls entsprechend ausgestaltet sein.

Die erfindungsgemäße Vorrichtung aus Fig. 10, verfügt über drei Ausgleichselemente an der Flächen des Fügepartners 202 bzw. jeweils ein Ausgleichselement an der ersten Seite 210, an der zweiten Seite 211 und an der Unterseite 212. Die Ausgleichselemente 203 sind dabei erfindungsgemäß angeordnet. Zwischen den Ausgleichselementen 203 befindet sich das Fixierelement 204. Dadurch kann Rissbildung weiter minimiert und die Dichtung redundant ausgelegt werden.

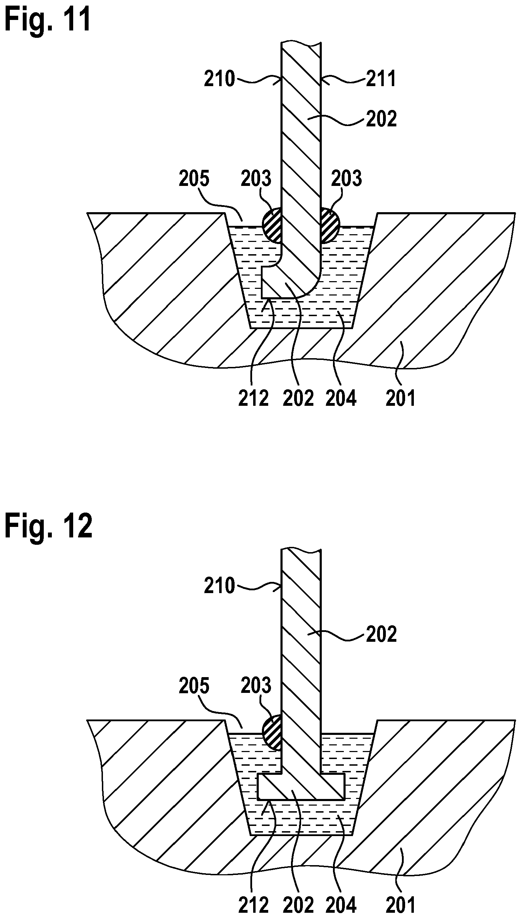

Der Fügepartner 202 kann an dem in das Fixierelement 204 eintauchenden Ende erfindungsgemäß eine einseitige Ausformung an der ersten Seite 210 oder an der zweiten Seite 211 aufweisen. Eine einseitige Ausformung an der ersten Seite 210 des Fügepartners 202 ist beispielsweise in Figur 11 dargestellt. Alternativ kann der Fügepartner 202 an dem in das Fixierelement 204 eintauchenden Ende eine zweiseitige Ausformung an der ersten Seite 210 und an der zweiten Seite 211 aufweisen, wie in Figur 12 dargestellt. Das Ausgleichselement 203 kann, wie in den vorangehenden Ausführungsbeispielen beschriebenen, an der ersten Seite 210, an der zweiten Seite 211 und/oder der Unterseite 212 angeordnet werden. Ausformungen des Fügepartners 202 an dem in das Fixierelement 204 eintauchenden Ende, wie in Fig. 11 und Fig. 12 dargestellt, erlauben eine Verstärkung der Fixierung durch das Fixierelement 204 und/oder eine Reduktion der Scherkräfte auf das auf dem Fügepartner 202 aufgebrachte Ausgleichselement 203 beim Eintauchen des Fügepartners 202 in das Fixierelement 204.

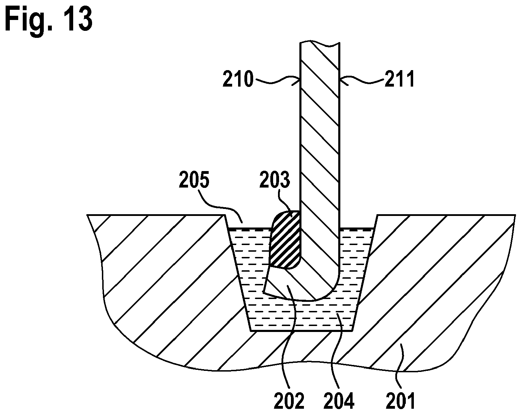

Wenn, wie in Fig. 13 dargestellt, das Ausgleichselement 203 an dem in das Fixierelement 204 eintauchenden Ende auf der gleichen Seite wie eine Ausformung des Fügepartners 202 und in Kontakt zur Ausformung, angeordnet ist, können beim Eintauchen des Fügepartners in das Fixierelement Scherkräfte auf das Ausgleichselement 203 und eine mögliche Bildung von Lufteinschlüssen innerhalb des Fixierelements 204 vermieden bzw. reduziert werden.

## Patentansprüche

1. Vorrichtung zur Fixierung eines Fügepartners umfassend
• ein Substrat (201), und
• einen Fügepartner (202), und
• ein Fixierelement (204), insbesondere ein Kleber,
wobei
• das Substrat (201) über eine mit dem Fixierelement (204) zumindest teilweise gefüllte Ausnehmung (205) auf der Substratoberfläche (226) verfügt, und
• der Fügepartner (202) in das Fixierelement (204) mit einer Eintauchtiefe (220) hineinragt, und
• der Fügepartner (202) durch das Fixierelement (204) fixiert wird,
***dadurch gekennzeichnet, dass***
ein Ausgleichselement (203), insbesondere aus einem elastischen Dichtmaterial,
• zwischen dem Fügepartner (202) und dem Fixierelement (204), und
• in Kontakt zum Fügepartner (202) und zum Fixierelement (204), und
• zumindest teilweise innerhalb der Eintauchtiefe (220) des Fügepartners (202) in das Fixierelement (205)
angeordnet ist, wobei
• eine thermische Ausdehnungsänderung oder
• eine mechanische Bewegung
des Fixierelementes (204), des Substrats (201) oder des Fügepartners (202) durch eine elastische Stauchung oder Dehnung des Ausgleichselementes (203) ausgeglichen wird.

2. Vorrichtung nach Anspruch 1 **dadurch gekennzeichnet, dass** das Ausgleichselement (203) an einer Fläche des Fügepartners bzw. an einer ersten Seite (210), an einer zweiten Seite (211) und/oder an der Unterseite (212) angeordnet wird.

3. Vorrichtung nach einem der Ansprüche 1 bis 2 **dadurch gekennzeichnet, dass** die Haftung zwischen dem Ausgleichselement (203) und dem Fügepartner (202) größer als die Haftung zwischen dem Ausgleichselement (203) und dem Fixierungselement (204) ist.

4. Vorrichtung nach einem der Ansprüche 1 bis 3 **dadurch gekennzeichnet, dass** eine Ausgleichselementbreite (228) mindestens ein Viertel einer Fixierelementbreite (304) beträgt.

5. Vorrichtung nach einem der Ansprüche 1 bis 4 **dadurch gekennzeichnet, dass** eine Anordnung des Ausgleichselementes (203) innerhalb der Eintauchtiefe (220) über eine Ausgleichshöhe (222) im Fixierelement (204) verfügt und die Ausgleichshöhe (222) mindestens ein Zehntel der Eintauchtiefe (220) beträgt.

6. Vorrichtung nach einem der Ansprüche 1 bis 5 **dadurch gekennzeichnet, dass** das Substrat (201), ein als Kappe ausgeprägter Fügepartner (202), das Ausgleichselement (203) und das Fixierelement (204) zusammen einen gegen die Umgebung (901) abgetrennten Raum (902) bilden, wobei das Substrat über einen von der Ausnehmung (205) auf der Substratoberfläche (226) eingeschlossenen Substratbereich (801) verfügt.

7. Vorrichtung nach Anspruch 6, wobei innerhalb des von der Ausnehmung (205) eingeschlossenen Substratbereiches (801) auf der Substratoberfläche (226) ein elektronisches Bauteil platziert wird.

8. Verfahren zur Fixierung eines Fügepartners umfassend folgender Verfahrensschritte
• eine Verwendung (101) eines Substrats (201) mit einer Ausnehmung (205), und
• ein Einbringen (102) eines Fixierelementes (204) in die Ausnehmung des Substrates (201), und
• ein Fügen (105) eines Fügepartners (202) mit einer Eintauchtiefe (220), in die mit dem Fixierelement (204) gefüllte Ausnehmung (205), und
• ein Aushärten (106) des Fixierelementes (204)
**dadurch gekennzeichnet, dass** zusätzlich
• ein Aufbringen (103) eines Ausgleichselementes (203) auf dem Fügepartner (202) oder der Oberfläche des Fixierelementes vor dem Fügen (105), und
• ein Aushärten (104) des Ausgleichselementes (203)
erfolgt, wobei das Ausgleichselement (203) nach dem Fügen (105) zumindest teilweise innerhalb der Eintauchtiefe (220) angeordnet ist.

9. Verfahren nach Anspruch 8 **dadurch gekennzeichnet, dass** die Aufbringung (102) des Ausgleichselementes (203) zumindest teilweise innerhalb der Eintauchtiefe (220) an einer Fläche des Fügepartners (202) bzw. an einer ersten Seite (210), einer zweiten Seite (211) und/oder an einer Unterseite (212) des Fügepartners erfolgt.

10. Verfahren nach einem der Ansprüche 8 bis 9 **dadurch gekennzeichnet, dass** die Aufbringung (103) des Ausgleichselementes (203) auf einer Fixierelementoberfläche (204) in der Ausnehmung (205) erfolgt, wobei die Fixierelementoberfläche zumindest teilweise bedeckt wird und der Fügepartner (202) nach dem Fügen (105) mit dem Ausgleichselement (203) und dem Fixierelement (204) in Kontakt ist.

11. Verfahren nach einem der Ansprüche 8 bis 10 **dadurch gekennzeichnet, dass** eine wenigstens teilweise Aushärtung (104) des Ausgleichselementes (203) vor und/oder nach dem Fügen (105) erreicht wird.

12. Verfahren nach einem der Ansprüche 8 bis 11 **dadurch gekennzeichnet, dass** ein teilweises Aushärten (106) des Fixierelementes (204) vor und/oder nach dem Fügen (105) erfolgt.

13. Verfahren nach einem der Ansprüche 8 bis 12 **dadurch gekennzeichnet, dass** die Ausnehmung (205) auf dem Substrat (201) einen Substratbereich (801) auf der Substratoberfläche (226) einschließt und ein als Kappe ausgeführter Fügepartner (202) verwendet wird, so dass durch das Fügen das Substrat (201), der Fügepartner (202), das Fixierelement (204) und das Ausgleichselement (203) einen gegen die Umgebung (901) abgetrennten Raum (902) ausbilden.

14. Verfahren nach Anspruch 13, wobei vor dem Fügen (105) innerhalb eines von einer Ausnehmung (205) eingeschlossenen Substratbereiches (801) ein elektronisches Bauteil platziert wird und dieses damit innerhalb des abgetrennten Raumes (902) vor schädlichen oder störenden Einflüssen aus der Umgebung (901) geschützt ist.

## Claims

1. Device for fixing a part to be joined, comprising:
• a substrate (201), and
• a part to be joined (202), and
• a fixing element (204), in particular an adhesive, wherein
• the substrate (201) has a recess (205) on the substrate surface (226) filled at least partially with the fixing element (204), and
• the part to be joined (202) protrudes into the fixing element (204) with a depth of immersion (220), and
• the part to be joined (202) is fixed by the fixing element (204),
**characterized in that**
a compensating element (203), in particular of an elastic sealing material, is arranged
• between the part to be joined (202) and the fixing element (204), and
• in contact with the part to be joined (202) and with the fixing element (204) and
• at least partially within the depth of immersion (220) of the part to be joined (202) in the fixing element (205),
wherein
• a change in thermal expansion or
• a mechanical movement
of the fixing element (204), of the substrate (201) or of the part to be joined (202) is compensated for by an elastic compression or elongation of the compensating element (203).

2. Device according to Claim 1, **characterized in that** the compensating element (203) is arranged on a surface of the part to be joined or on a first side (210), on a second side (211) and/or on the underside (212).

3. Device according to either of Claims 1 and 2, **characterized in that** the bonding between the compensating element (203) and the part to be joined (202) is greater than the bonding between the compensating element (203) and the fixing element (204).

4. Device according to one of Claims 1 to 3, **characterized in that** a compensating element width (228) is at least one fourth of a fixing element width (304).

5. Device according to one of Claims 1 to 4, **characterized in that** an arrangement of the compensating element (203) within the depth of immersion (220) has a compensating height (222) in the fixing element (204) and the compensating height (222) is at least one tenth of the depth of immersion (220) .

6. Device according to one of Claims 1 to 5, **characterized in that** the substrate (201), a part to be joined (202) shaped as a cap, the compensating element (203) and the fixing element (204) together form a space (902) separated from the surroundings (901), wherein the substrate has a substrate area (801) enclosed by the recess (205) on the substrate surface (226).

7. Device according to Claim 6, wherein an electronic component is placed within the substrate area (801) enclosed by the recess (205) on the substrate surface (226) .

8. Method for fixing a part to be joined, comprising the following method steps
• using (101) a substrate (201) having a recess (205), and
• introducing (102) a fixing element (204) into the recess of the substrate (201), and
• joining (105) a part to be joined (202) with a depth of immersion (220) into the recess (205) filled with the fixing element (204), and
• curing (106) the fixing element (204), **characterized in that** in addition
• applying (103) a compensating element (203) on the part to be joined (202) or the surface of the fixing element before the joining (105), and
• curing (104) the compensating element (203),
are performed, wherein the compensating element (203) is arranged at least partially within the depth of immersion (220) after the joining (105).

9. Method according to Claim 8, **characterized in that** the application (102) of the compensating element (203) takes place at least partially within the depth of immersion (220) on a surface of the part to be joined (202) or on a first side (210), a second side (211) and/or on an underside (212) of the part to be joined.

10. Method according to either of Claims 8 and 9, **characterized in that** the application (103) of the compensating element (203) takes place on a fixing element surface (204) in the recess (205), wherein the fixing element surface is at least partially covered and the part to be joined (202) is in contact with the compensating element (203) and the fixing element (204) after the joining (105).

11. Method according to one of Claims 8 to 10, **characterized in that** an at least partial curing (104) of the compensating element (203) is achieved before and/or after the joining (105).

12. Method according to one of Claims 8 to 11, **characterized in that** a partial curing (106) of the fixing element (204) takes place before and/or after the joining (105).

13. Method according to one of Claims 8 to 12, **characterized in that** the recess (205) on the substrate (201) encloses a substrate area (801) on the substrate surface (226) and a part to be joined (202) designed as a cap is used, so that, as a result of the joining, the substrate (201), the part to be joined (202), the fixing element (204) and the compensating element (203) form a space (902) separated from the surroundings (901).

14. Method according to Claim 13, wherein an electronic component is placed within a substrate area (801) enclosed by a recess (205) before the joining (105) and this component is consequently protected within the separated space (902) against harmful or disruptive influences from the surroundings (901).

## Revendications

1. Dispositif de fixation d'un partenaire d'assemblage, le dispositif comprenant
• un substrat (201) et
• un élément d'assemblage associé (202), et
• un élément de fixation (204), en particulier un adhésif,
• le substrat (201) comportant un évidement (205), au moins partiellement rempli de l'élément de fixation (204), sur la surface de substrat (226), et
• l'élément d'assemblage associé (202) faisant saillie dans l'élément de fixation (204) à une profondeur de pénétration (220), et
• l'élément d'assemblage associé (202) étant fixé par l'élément de fixation (204),
**caractérisé en ce que**
un élément de compensation (203), notamment en un matériau d'étanchéité élastique, est disposé
• entre l'élément d'assemblage associé (202) et l'élément de fixation (204), et
• en contact avec l'élément d'assemblage associé (202) et l'élément de fixation (204), et
• au moins partiellement dans la profondeur de pénétration (220) de l'élément d'assemblage associé (202) dans l'élément de fixation (205),
• une variation de dilatation thermique ou
• un mouvement mécanique de l'élément de fixation (204), du substrat (201) ou de l'élément d'assemblage associé (202) étant compensé par une compression ou une dilatation élastique de l'élément de compensation (203) .

2. Dispositif selon la revendication 1, **caractérisé en ce que** l'élément de compensation (203) est disposé sur une surface de l'élément d'assemblage associé ou sur un premier côté (210), sur un deuxième côté (211) et/ou sur le côté inférieur (212).

3. Dispositif selon l'une des revendications 1 à 2 **caractérisé en ce que** l'adhérence entre l'élément de compensation (203) et l'élément d'assemblage associé (202) est supérieure à l'adhérence entre l'élément de compensation (203) et l'élément de fixation (204).

4. Dispositif selon l'une des revendications 1 à 3, **caractérisé en ce qu'**une largeur d'élément de compensation (228) est d'au moins un quart d'une largeur d'élément de fixation (304).

5. Dispositif selon l'une des revendications 1 à 4, **caractérisé en ce qu'**un agencement de l'élément de compensation (203) à l'intérieur de la profondeur de pénétration (220) présente une hauteur de compensation (222) dans l'élément de fixation (204) et la hauteur de compensation (222) est d'au moins un dixième de la profondeur de pénétration (220).

6. Dispositif selon l'une des revendications 1 à 5, **caractérisé en ce que** le substrat (201), un élément d'assemblage associé (202) estampé sous forme de capuchon, l'élément de compensation (203) et l'élément de fixation (204) forment conjointement un espace (902) séparé de l'environnement (901), le substrat comportant une région de substrat (801) entourée par l'évidement (205) sur la surface de substrat (226).

7. Dispositif selon la revendication 6, un composant électronique est placé sur la surface de substrat (226) dans la région de substrat (801) entourée par l'évidement (205).

8. Procédé de fixation d'un élément d'assemblage associé, le procédé comprenant les étapes suivantes
• une utilisation (101) d'un substrat (201) avec un évidement (205) et
• une introduction (102) d'un élément de fixation (204) dans l'évidement du substrat (201), et
• un assemblage (105) d'un élément d'assemblage associé (202) avec une profondeur de pénétration (220) dans l'évidement (205) rempli de l'élément de fixation (204), et
• un durcissement (106) de l'élément de fixation (204),
**caractérisé en ce qu'**il est en outre effectué
• une application (103) d'un élément de compensation (203) sur l'élément d'assemblage associé (202) ou la surface de l'élément de fixation avant l'assemblage (105), et
• un durcissement (104) de l'élément de compensation (203), l'élément de compensation (203) étant disposé après la jonction (105) au moins partiellement dans la profondeur de pénétration (220).

9. Procédé selon la revendication 8, **caractérisé en ce que** l'application (102) de l'élément de compensation (203) au moins partiellement dans la profondeur de pénétration (220) est effectuée sur une surface de l'élément d'assemblage associé (202) ou sur un premier côté (210), un deuxième côté (211) et/ou sur un côté inférieur (212) de l'élément d'assemblage associé.

10. Procédé selon l'une des revendications 8 à 9, **caractérisé en ce que** l'application (103) de l'élément de compensation (203) est effectuée sur une surface d'élément de fixation (204) dans l'évidement (205), la surface d'élément de fixation étant au moins partiellement recouverte et l'élément d'assemblage associé (202) étant en contact après l'assemblage (105) avec l'élément de compensation (203) et l'élément de fixation (204).

11. Procédé selon l'une des revendications 8 à 10, **caractérisé en ce qu'**un durcissement au moins partiel (104) de l'élément de compensation (203) est effectué avant et/ou après l'assemblage (105).

12. Procédé selon l'une des revendications 8 à 11, **caractérisé en ce qu'**un durcissement partiel (106) de l'élément de fixation (204) est effectué avant et/ou après l'assemblage (105).

13. Procédé selon l'une des revendications 8 à 12, **caractérisé en ce que** l'évidement (205) sur le substrat (201) entoure une région de substrat (801) sur la surface de substrat (226) et un élément d'assemblage associé (202) conçu comme capuchon est utilisé de telle sorte que l'assemblage permet au substrat (201), à l'élément d'assemblage associé (202), à l'élément de fixation (204) et à l'élément de compensation (203) de former un espace (902) séparé de l'environnement (901).

14. Procédé selon la revendication 13, un composant électronique étant placé avant l'assemblage (105) dans une région de substrat (801) entourée par l'évidement (205) et ce composant étant protégé donc dans l'espace séparé (902) contre des influences néfastes ou gênantes de l'environnement (901).
